# EUROPEAN PATENT SPECIFICATION

(11) **EP 0 507 126 B1**
(45) Date of publication and mention of the grant of the patent: **04.06.1997**
(21) Application number: 92104227.1
(22) Date of filing: 11.03.1992
(51) Int. Cl.: G01R 1/02, G01R 15/12

(54) **Input protecting mechanism for measuring device**
Schutzvorrichtung für den Eingangsschutz eines Messinstrumentes
Dispositif de protection de l'entrée d'un instrument de mesure

(30) Priority: 05.04.1991 JP 31122/91 U
(43) Date of publication of application: 07.10.1992
(73) Proprietor: YOKOGAWA INSTRUMENTS CORPORATION, Koushoku-shi, Nagano-ken 387 (JP)
(72) Inventor: Nakazawa, Tosio, Chiisagata-gun, Nagano-ken 386-16 (JP); Kitajima, Akihiko, Nagano-shi, Nagano-ken 381-22 (JP)
(74) Representative: Henkel, Feiler, Hänzel & Partner

(56) References cited:
- EP-A- 0 474 086
- DE-C- 1 082 655

## Description

### BACKGROUND OF THE INVENTION

### Field of the Invention

The present invention relates to an input protecting mechanism for a measuring device and, more particularly, to a prevention of an erroneous input which might otherwise follow an erroneous insertion of the plug of a test lead.

### Description of the Prior Art

The input protecting device for a measuring device is exemplified in the prior art by Japanese Utility Model Publication No. 39333/1987.

The invention disclosed in the Publication is intended to prevent a tester, in which a high-voltage measuring input terminal is disposed independently of a low-voltage measuring input terminal, from having the plug of a test lead inserted, when a high voltage is to be measured, into the low-voltage measuring input terminal.

In the invention thus disclosed, therefore, the test lead plug is allowed to be inserted only into the high-voltage measuring input terminal by shutting the low-voltage measuring input terminal automatically with a shutter in response to a selection of a range in case a range select switch is switched to a high-voltage measuring range.

With this construction, it is possible to prevent the low-voltage measuring input terminal from being fed with an excessive input.

With the construction of the prior art, however, the high-voltage measuring input terminal is open at all times, and the low-voltage measuring input terminal is also opened in case the range select switch is switched to a range other than the high-voltage measuring range. Thus, when the range select switch is switched to the range other than the high-voltage measuring range, the plug of a test lead for measuring a high voltage might be inserted into the low-voltage measuring input terminal to damage the internal circuit of the tester with the excessive input.

### SUMMARY OF THE INVENTION

An object of the present invention is to provide an input protecting mechanism for a measuring device, which can prevent an internal circuit irrespective of the selected state of a measurement range from being damaged by an erroneous input caused by an erroneous insertion of the plug of a test lead.

According to the present invention, there is provided an input protecting mechanism for a measuring device comprising: a function select switch for selecting measurement functions; a plurality of input terminals for receiving the plug of a test lead selectively in accordance with the measurement function selected; and a shutter made movable in accordance with the select range of the function select switch for opening or closing a predetermined one of the input terminals. The shutter includes: an actuate portion adapted to be actuated from the outside; contacts for opening or closing at least the predetermined one of the input terminals in accordance with the actuation of the actuate portion; and an engage portion adapted to engage with a portion of the function select switch, when the predetermined input terminal is opened, to regulate the select range of the function select switch, and to engage with a portion of the function select switch, when the predetermined input terminal is closed, to regulate the movement of the shutter.

### BRIEF DESCRIPTION OF THE DRAWINGS

Other objects and advantages of the present invention will become apparent from the following description to be made with reference to the accompanying drawings, in which:
Fig. 1 is a perspective view showing the assembly of an essential portion according to one embodiment of the present invention;
Fig. 2 is an external view of Fig. 1; and
Fig. 3 is an explanatory view showing the operations of Fig. 1.

### DESCRIPTION OF THE PREFERRED EMBODIMENT

The embodiment of the present invention will be described in detail in the following with reference to the accompanying drawings.

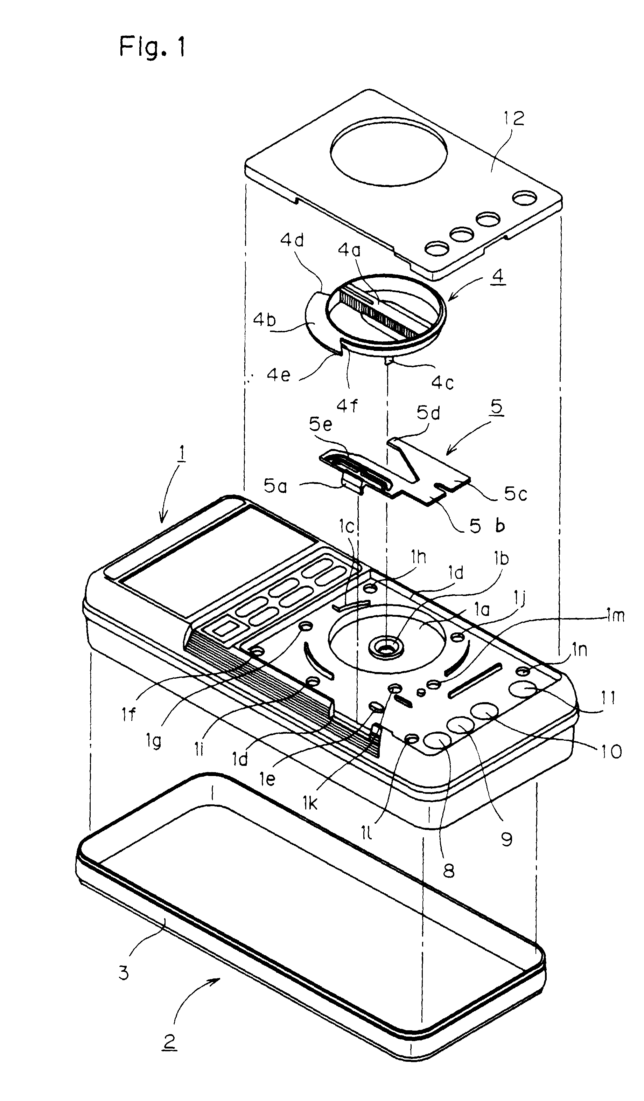

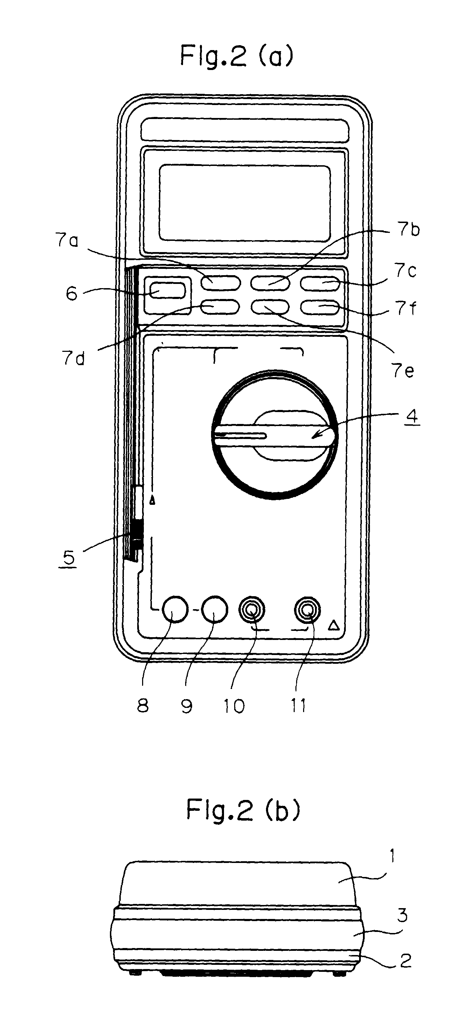

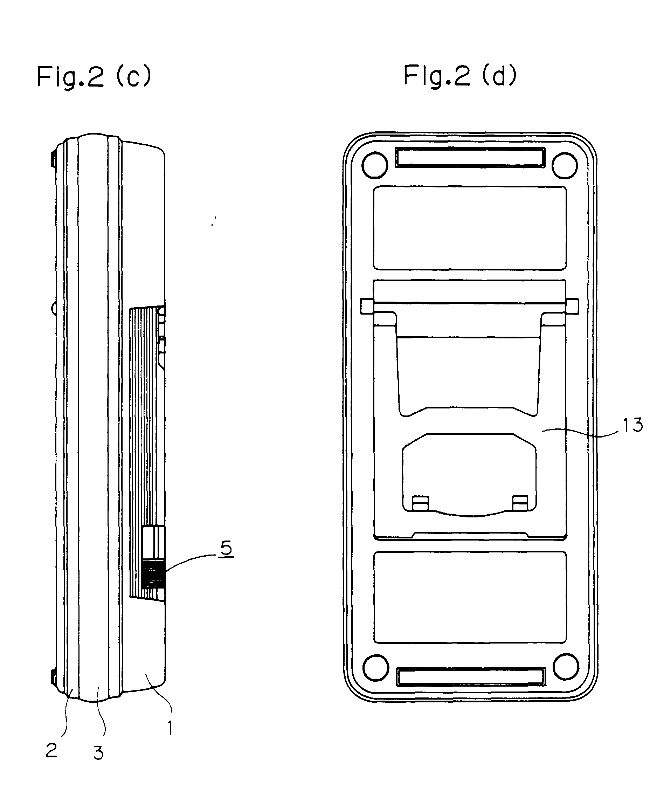

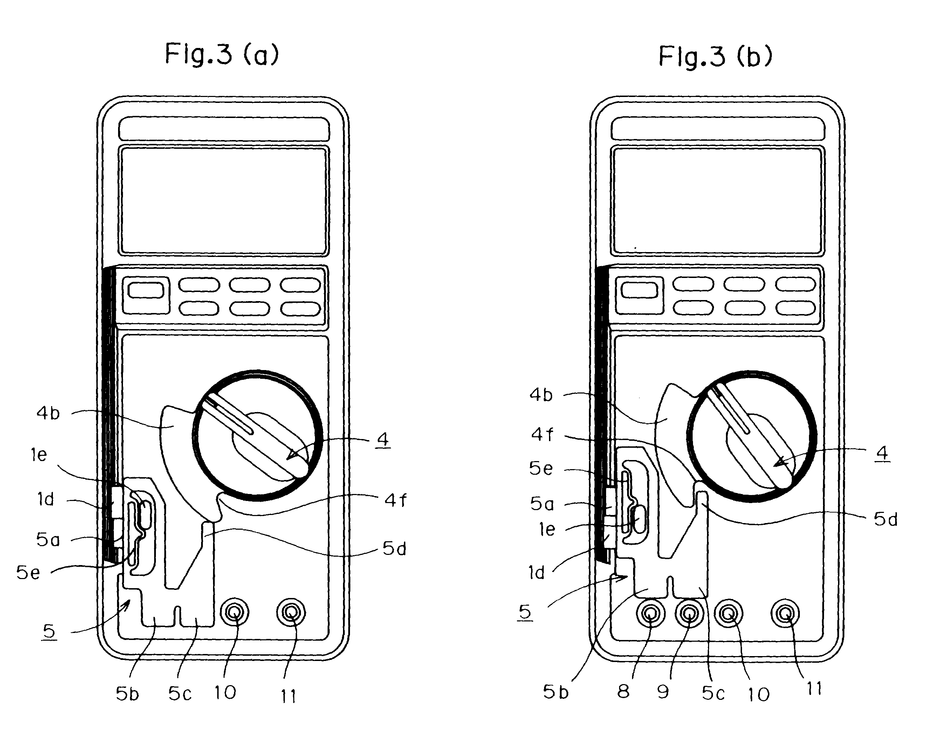

Fig. 1 is a perspective view showing the assembly of an essential portion of the present invention and illustrates an example of a digital multi-meter. In Fig. 2 presenting an external view of Fig. 1: (a) a top plan view; (b) a front elevation; (c) a side elevation; and (d) a bottom view. In Fig. 3 presenting an explanatory view of the operations of Fig. 1, (a) shows a state in which a shutter is closed, and (b) shows a state in which the shutter is closed.

In these Figures: reference numeral 1 designates an upper casing; numeral 2 a lower casing; numeral 3 a seal made of an elastic material. These casings 1 and 2 are fixed from the bottom of the casing 2 by means of not-shown screws by fitting the casings 1 and 2 with the casings 1 and 2 accommodating an inner casing therein and with the seal 3 being fitted around the outer circumference of the end face of the casing 1.

The not-shown inner casing is attached to the back of the upper casing 1. To the surface of the upper casing 1, there are attached a function select switch 4 adapted to be actuated from the outside for selecting measurement functions, a shutter 5, a power switch 6, and operation mode select switches 7a to 7f. The upper casing 1 is equipped with a plurality of input terminals 8 to 11, into which the plug of a not-shown test lead is selectively inserted in accordance with a measurement function to be set.

Reference numeral 12 designates a panel to be attached to the surface of the upper casing 1. The panel 12 is formed with a plurality of holes for exposing the function select switch 4 and the input terminals 8 to 11 to the outside and is printed with function indicating letters or symbols of the individual units.

Reference numeral 13 designates a stand which is removably attached to the back of the lower casing 2.

The constructions of the individual portions will be described in the following.

The function select switch 4 functions as a rotary switch to be clicked at a constant angular pitch and switches, in the present embodiment, the nine fundamental measuring functions: "an AC voltage", "a DC voltage", "a DC voltage of 500 mV", "a resistance", "a diode check", "a current of 500 µ A", "a current of 500 µ A", "a current of 500 mA", and "a current of 10 A".

This function select switch 4 is formed generally into a circular shape and with a control knob 4a disposed in a diametrical direction. An arcuate engage portion 4b is formed in a circumferential partial portion of the control knob 4b and is made integral with a pin 4c. This pin is so inserted in a center hole 1b which is formed at the center of a circular recess 1a formed in the surface of the upper casing 1. One end 4d of the engage portion 4b is formed in the vicinity of the outer circumference of the recess 1a of the upper casing 1 to form a stopper 1c for regulating one end of the rotational range of the function select switch 4. The engage portion 4b has its other end 4e formed with a notch 4f and abutting against a side wall 1d of the upper casing 1 to regulate the other end of the rotational range of the function select switch 4.

The shutter 5 is formed integral with: an actuate portion 5a which is into such an L-shape and adapted to be actuated from the outside of the side that the side wall of the upper casing 1 may have its portion slidably engaging with the cut-away notch 1d in accordance with the moving range of the shutter 5; contacts 5b and 5c for opening or closing two predetermined ones 8 and 9 of the plurality of input terminals 8 to 11 in accordance with the selections; an engage portion 5d adapted to engage with the notch 4f of the engage portion 4b formed in the portion of the function select switch 4, when the predetermined input terminals 8 and 9 are opened, to regulate the select range of the function select switch 4 and to contact with the outer peripheral of the engage portion 4b formed in the portion of the function select switch 4, when the predetermined input terminals 8 and 9 are closed, to regulate the movement of the shutter; and a spring 5e for pushing a projection 1e, which is formed on the surface of the upper casing 1 along the moving direction of the shutter 5, to giving a clicking feel according to the selected position.

The switch 7a is set to a relative mode for indicating a change in the measured value; the switch 7b i set to a mode for indicating the maximum and minimum of the measured value; the switch 7c is set to a mode for switching the indicated value to four and a half figures and three and a half figures; the switch 7d is set to a mode for holding the measured value; the switch 7e is set to a mode for holding the indication range; and the switch 7f selects the plurality of functions assigned in advance to the individual function ranges selected by the function select switch 4.

In the present embodiment, more specifically, the switch 7f is operated to switch: the indication object of the measured value to a frequency or voltage and the voltage indication to V or dbm, in the "AC voltage" function; the voltage indication to V or dbm in the "DC voltage" function; the indication to that of the measured value using an adapter for outputting a DC voltage in the "DC voltage or 500 mV" function; the indication to an alarm indication, a resistance measurement by a power of one tenth as low as the ordinary value or the temperature measurement by a thermistor in the "resistance" function; the polarity of the applied voltage in the "diode check" function; and interchange the AC current and the DC current in the individual current measuring functions of the "current of 500 µ A", the "current of 50 mA", the "current of 500 mA" and the "current of 10A".

The input terminal 8 is a current input terminal, into which the plug of a test lead at the plus side is selectively inserted for measuring a current of 10A, and has a fuse of proper allowable current connected in series. The input terminal 9 is a current input terminal, into which the plug of a test lead at the plus side is selectively inserted for measuring currents of mA and µ A, and has a fuse of proper allowable current connected in series. The input terminal is a common input terminal, into which the plug of a test lead at the minus side is commonly inserted for a variety of measurements. The input terminal 11 is a resistance/voltage input terminal, into which the plug of a test lead at the plus side is selectively inserted for a measurement other than the current measurement.

The panel 12 has its back made integral with a plurality of projections which engage with a plurality of positioning holes 1f to 1n formed in the opposed face of the upper casing 1.

The operations of the structure thus made will be described in the following.

The shutter 5 is selected by a user, as shown in Fig. 3(a) and 3(b). Fig. 3(a) shows the state, in which the input terminals 8 and 9 are closed by the shutter 5, and Fig. 3(b) shows the state, in which the input terminals 8 and 9 are opened by the shutter 5.

In the state of Fig. 3(a), the engagement between the notch 4f of the function select switch 4 and the engage portion 5d of the shutter 5 is released so that the function select switch 4 can rotate so far as the other end 4e of the engage portion 4b comes into abutment against the side wall 1d.

Since, in this state, the current input terminals 8 and 9 are shut by the shutter 5, the plug of any test lead is not inserted into the current input terminals 8 and 9. Since these current input terminals 8 and 9 have small input resistances, they might allow a high current to flow therethrough, if a voltage is applied, thereby to burn the internal circuit, to melt the fuse or to cause a human accident in the worst case. Despite of this danger, however, the current input terminals 8 and 9 are not opened to enhance the safety so long as the user is convinced of the current measurement to switch the function select switch 4 to the current measuring function thereby to open the shutter 5.

If the function select switch 4 is turned clockwise from the state of Fig. 3(a) to set the "current of 500 µ A" function, the state of Fig. 3(b) is entered, in which the actuate portion 5a of the shutter 5 can be operated. If, moreover, the actuate portion 5a is operated, the engage portion 5d of the shutter 5 comes into engagement with the notch 4f of the function select switch 4 so that it functions as a stopper for inhibiting any counter-clockwise rotation.

Since, in this state, the current input terminals 8 and 9 are opened, the current measurement can be accomplished by inserting the test lead plugs into either of the current input terminals 8 and 9 and the common input terminal 10. Incidentally, the input terminal 11 has a high input resistance so that it raises no dangerous state even if fed with a current.

Moreover, in case the shutter 5 is thus opened or in case the test lead plug is inserted into either of the current input terminals 8 and 9, the function select switch 4 cannot be switched to a measuring function other than the current measurement.

If this state is switched to a measuring function such as the "AC voltage" function other than the current measurement to measure the voltage, the plug of the test lead fitted in the current input terminal 8 or 9 is extracted and inserted again into the input terminal 11, and the function select switch 4 is selected to the "AC voltage" function after the actuate portion 5a of the shutter 5 has been operated to close the current input terminals 8 and 9.

As a result, the internal circuit can be prevented from being damaged by an erroneous input with the test lead plug being left in the current input terminal 8 or 9, in case the function is switched from the current measuring function to a measuring function other than the current measurement.

Incidentally, the foregoing embodiment thus far described is directed to one in which the current input terminals in the digital multi-meter are opened or closed by the shutter, but other terminals could be selectively opened or closed in accordance with the application.

As has been described hereinbefore, according to the present invention, it is possible to achieve an input protecting mechanism for a measuring device, which can prevent the internal circuit from being damaged by an erroneous input irrespective of the selected state of the measuring range.

## Claims

1. An input protecting mechanism for a measuring device comprising: a function select switch (4) for selecting measurement functions; a plurality of input terminals (8-11) for receiving the plug of a test lead selectively in accordance with the measurement function selected; and a shutter (5) made movable in accordance with the select range of said function select switch (4) for opening or closing a predetermined one of said input terminals (8-11),
wherein said shutter (5) includes:
an actuate portion (5a) adapted to be actuated from the outside;
contacts (5b,5c) for opening or closing at least the predetermined one of said input terminals (8-11) in accordance with the actuation of said actuate portion; and
an engage portion (5d) adapted to engage with a portion (4b,4f) of said function select switch (4), when said predetermined input terminal is opened, to regulate the select range of said function select switch (4), and to engage with a portion of said function select switch (4), when said predetermined input terminal is closed, to regulate the movement of said shutter (5).

2. An input protecting mechanism according to Claim 1, wherein said shutter (5) further includes a spring (5e) for giving said shutter (5) a clicking feel according to the selected position.

## Patentansprüche

1. Eingangsschutzvorrichtung für ein Meßgerät mit:
einem Funktionswahlschalter (4) zur Auswahl der Meßfunktionen; einer Vielzahl von Eingangsanschlüssen (7-11) zur selektiven Aufnahme des Steckers eines Testkabels gemäß der gewählten Meßfunktion; und einem Verschluß (5) der gemäß dem gewählten Bereich des Funktionswahlschalters (4) verschieblich ist, um einen vorgegebenen der Eingangsanschlüsse (8-11) zu öffnen oder zu schließen,
wobei der Verschluß (5) folgendes beinhaltet:
einen zur Betätigung von außen angepaßten Betätigungsabschnitt (5a);
Kontakte (5b, 5c) zum Öffnen oder Schließen mindestens eines vorgegebenen der Eingangsanschlüsse (8-11) gemäß der Betätigung des Betätigungsabschnitts; und
einen Eingriffsabschnitt (5d), der so ausgeführt ist, daß er mit einem Abschnitt (4b, 4f) des Funktionswahlschalters (4) in Eingriff steht, wenn der vorgegebene Eingangsanschluß geöffnet ist, um den Wahlbereich des Funktionswahlschalters (4) zu regeln, und daß er mit einem Abschnitt des Funktionswahlschalters (4) in Eingriff steht, wenn der vorgegebene Eingangsanschluß geschlossen ist, um die Bewegung des Verschlusses (5) zu regeln.

2. Eingangsschutzvorrichtung gemäß Anspruch 1, dadurch gekennzeichnet, daß der Verschluß (5) weiterhin eine Feder (5e) enthält, so daß der Verschluß (5) entsprechend der gewählten Position spürbar einrastet.

## Revendications

1. Un dispositif de protection de l'entrée d'un instrument de mesure, comportant : un commutateur (4) de sélection de fonctions pour sélectionner des fonctions de mesure ; une pluralité de bornes d'entrée (8 - 11) pour recevoir sélectivement la fiche d'un câble de test en concordance avec la fonction de mesure sélectionnée ; et un volet (5) rendu mobile en concordance avec la plage de sélection dudit commutateur (4) de sélection de fonctions pour ouvrir ou fermer l'une prédéterminée desdites bornes d'entrée (8 - 11),
dans lequel ledit volet (5) comporte :
une partie d'actionnement (5a) agencée pour être actionnée depuis l'extérieur ;
des contacts (5b, 5c) pour ouvrir ou fermer au moins celle desdites bornes d'entrée (8 - 11) qui est prédéterminée, en concordance avec l'actionnement de ladite partie d'actionnement ; et
une partie de coopération (5d) agencée pour coopérer avec une partie (4b, 4f) dudit commutateur (4) de sélection de fonctions lorsque ladite borne d'entrée prédéterminée est ouverte, de manière à réguler la plage de sélection dudit commutateur (4) de sélection de fonctions, et pour coopérer avec une partie dudit commutateur (4) de sélection de fonctions lorsque ladite borne d'entrée prédéterminée est fermée, de manière à réguler le mouvement dudit volet (5).

2. Un dispositif de protection d'entrée selon la revendication 1, dans lequel ledit volet (5) comporte au surplus un ressort (5e) pour donner audit volet (5) un effet de déclic selon la position sélectionnée.
